# EUROPEAN PATENT SPECIFICATION

(11) **EP 2 614 121 B1**
(45) Date of publication and mention of the grant of the patent: **06.03.2019**
(21) Application number: 11823139.8
(22) Date of filing: 06.09.2011
(51) Int. Cl.: C09G 1/02, C09G 1/04, C09G 1/18, C09K 3/14, C08L 33/24, H01L 21/3105

(54) **AQUEOUS POLISHING COMPOSITION AND PROCESS FOR CHEMICALLY MECHANICALLY POLISHING SUBSTRATES FOR ELECTRICAL, MECHANICAL AND OPTICAL DEVICES**
WÄSSRIGE POLIERZUSAMMENSETZUNG UND VERFAHREN ZUM CHEMISCH-MECHANISCH POLIEREN VON SUBSTRATEN FÜR ELEKTRISCHE, MECHANISCHE UND OPTISCHE VORRICHTUNGEN
COMPOSITION AQUEUSE DE POLISSAGE ET PROCÉDÉ DE POLISSAGE MÉCANO-CHIMIQUE DE SUBSTRATS POUR DES DISPOSITIFS ÉLECTRIQUES, MÉCANIQUES ET OPTIQUES

(30) Priority: 08.09.2010 US 380721 P
(43) Date of publication of application: 17.07.2013
(73) Proprietor: BASF SE, 67056 Ludwigshafen am Rhein (DE)
(72) Inventor: LI, Yuzhuo, 69123 Heidelberg (DE); CHU, Jea-Ju, Taipei City 111 (TW); VENKATARAMAN, Shyam Sundar, Zhongli City Taoyuan County 320 (TW); USMAN IBRAHIM, Sheik Ansar, Potsdam NY 13676 (US); PINDER, Harvey Wayne, Chicago IL 60659 (US)
(74) Representative: BASF IP Association
(86) International application number: PCT/IB2011/053884
(87) International publication number: WO 2012/032461

(56) References cited:
- WO-A1-2006/001558
- CN-A- 1 417 278
- SU-A1- 490 811
- US-A- 6 110 832
- US-A1- 2007 077 865
- US-B1- 6 616 514

## Description

The present invention is directed to a novel aqueous polishing composition which is particularly suitable for polishing substrates for electrical, mechanical and optical devices.

Moreover, the present invention is directed to a novel process for polishing substrates for manufacturing electrical, mechanical and optical devices.

Last but not least, the present invention is directed to the novel use of the novel aqueous polishing composition for manufacturing electrical, mechanical and optical devices

### Cited Documents

The documents cited in the present application are incorporated by reference in their entirety.

### Background of the Invention

Chemical mechanical planarization or polishing (CMP) is the primary process to achieve local and global planarity of integrated circuits (ICs) devices. The technique typically applies CMP compositions or slurries containing abrasives and other additives as an active chemistry between a rotating substrate surface and a polishing pad under an applied load. Thus, the CMP process couples a physical process such as abrasion with a chemical process such as oxidation or chelation. It is not desirable for the removal or polishing of substrates to be comprised of purely physical or purely chemical action, but rather the synergistic combination of both in order to achieve a fast uniform removal.

This way, the substrate is removed until the desired planarity is achieved or a barrier sublayer or stopping layer is exposed. Ultimately, a planar, defect-free surface is obtained which enables proper multilayer IC device fabrication by subsequent photolithography, patterning, etching and thin-film processing.

Shallow trench isolation (STI) is a specific CMP application which generally requires the selective removal of silicon dioxide to silicon nitride on a patterned wafer substrate. In this case, etched trenches are overfilled with a dielectric material, e.g., silicon dioxide, which is polished using the silicon nitride barrier film as the stopping layer. The CMP process ends with clearing the silicon dioxide from the barrier film while minimizing the removal of exposed silicon nitride and trench silicon oxide.

This requires CMP slurries capable of achieving a high relative ratio of silicon dioxide material removal rate MRR to silicon nitride removal rate MRR which ratio is also referred to in the art as oxide-to-nitride selectivity.

Ceria-based CMP slurries have received considerable attention in STI applications because of their ability to achieve a comparatively high oxide-to-nitride selectivity due to the high chemical affinity of ceria to silicon dioxide which is also referred to in the art as the chemical tooth action of ceria.

Nevertheless, the oxide-to-nitride selectivity of ceria-based CMP slurries must be improved by additives which "tailor" the selectivity.

Numerous attempts have been made to tailor the selectivity of ceria-based CMP slurries.

Thus, Jae-Don Lee et al. disclose in Journal of the Electrochemical Society, 149 (8), G477-G481, 2002, the effects of nonionic surfactants with different hydrophile-lipophile-balance (HLB) values such as polyethyleneoxides, ethyleneoxide-propyleneoxide copolymers and ethyleneoxide-propyleneoxide-ethyleneoxide triblock copolymers on oxide-to-polysilicon selectivity during CMP. However, fumed silica is used as the abrasive.

Jae-Dong Lee et al. disclose in Journal of the Electrochemical Society, 149 (8) G477-G481, 2002, Effects of Nonionic Surfactants on Oxide-To-Polysilicon Selectivity during Chemical Mechanical Polishing, the influence of surfactants such as polyethylene oxide (PEO) and ethyleneoxide-propyleneoxide-ethyleneoxide triblock copolymers on the selectivity. However, the oxide-to-nitride selectivity is not addressed.

The American patent application US 2002/0034875 A1 and the American patent US 6,626,968 B2 disclose a ceria-based CMP slurry containing surfactants, pH adjusting agents such as potassium hydroxide, sulfuric acid, nitric acid, hydrochloric acid or phosphoric acid, and polymers containing a hydrophilic functional group and a hydrophobic functional group such as polyvinyl methyl ether (PVME), polyethylene glycol (PEG), polyoxyethylene 23 lauryl ether (POLE), polypropanoic acid (PPA), polyacrylic acid (PM), and polyether glycol bis ether (PEGBE). The ceria-based CMP slurry has an increased the oxide-to-polysilicon selectivity.

The American patent US 6,616,514 B1 discloses a ceria-based CMP slurry containing organic polyols having at least 3 hydroxyl groups that are not dissociable in the aqueous medium; or a polymer formed from at least one monomer having at least 3 hydroxyl groups that are not dissociable in the aqueous medium such as mannitol, sorbitol, mannose, xylitol, sorbose, sucrose, and dextrin for improving the oxide-to-nitride selectivity.

The American patent application US 2006/0124594 A1 discloses a ceria-based CMP slurry having a viscosity of at least 1.5 cP and comprising a viscosity increasing agent including a nonionic polymer such as polyethylene glycol (PEG). The ceria-based CMP slurry is said to have a high oxide-to-nitride selectivity and a low within-wafer non-uniformity WIWNU.

The American patent application US 2006/0207188 A1 discloses a ceria-based CMP slurry containing the reaction product of a polymer such as polyacrylic acid or poly(alkyl methacrylate) and a monomer such as acrylamide, methacrylamide, ethyl-methacrylamide, vinylpyridine, or vinylpyrrolidone. The reaction products are believed to increase also the oxide-to-nitride selectivity.

The American patent application US 2006/0216935 A1 discloses a ceria-based CMP slurry comprising protein, lysine and/or arginine and a pyrrolidone compounds such as polyvinylpyrrolidone (PVP), N-octyl-2-pyrrolidone, N-ethyl-2-pyrrolidone, N-hydroxyethyl-2-pyrrolidone, N-cyclohexyl-2-pyrrolidone, N-butyl-2-pyrrolidone, N-hexyl-2-pyrrolidone, N-decyl-2-pyrrolidone, N-octadecyl-2-pyrrolidone, and N-hexadecyl-2-pyrrolidone. The ceria-based CMP slurry can furthermore contain dispersing agents like polyacrylic acid, glycols and polyglycols. Specific examples use proline, polyvinylpyrrolidone or N-octyl-2-pyrrolidone, PPO/PEO blockcopolymers, and glutaraldehyde. The ceria-based CMP slurry is believed to not aggressively remove trench silicon dioxide thereby allowing for extended polishing beyond the endpoint without substantially increasing the minimum step height.

The American patent application US 2007/0077865 A1 discloses a ceria-based CMP slurry containing polyethyleneoxides/polypropyleneoxide copolymers preferably from the Pluronic™ family sold by BASF. The ceria-based CMP slurry can furthermore contain amino alcohols such as 2-dimethylamino-2-methyl-1-propanol (DMAMP), 2-amino-2-ethyl-1-propanol (AMP), 2-(2-aminoethylamino)ethanol, 2-(isopropylamino)ethanol, 2-(methylamino)ethanol, 2-(diethylamino)ethanol, 2-(2-dimethylamino)ethoxy)ethanol, 1,1 '-[[3-(dimethylamino)propyl]imino]-bis-2-propanol, 2-(2-butylamino)ethanol, 2-(tert-butylamino)ethanol, 2-(diisopropylamino)ethanol, and N-(3-aminopropyl)morpholine. The ceria-based CMP slurry may furthermore contain quaternary ammonium compounds like tetramethylammonium hydroxide, film forming agents such as alkyl amines, alkanolamines, hydroxyl amines, phosphate esters, sodium lauryl sulfate, fatty acids, polyacrylates, polymethacrylates, polyvinylphosphonates, polymalates, polystyrene sulfonate, polyvinyl sulfate, benzotriazole, triazole, and benzoimidazole, and complexing agents such as acetylacetone, acetates, glycolates, lactates, gluconates, gallic acid, oxalates, phthalates, citrates, succinates, tartates, malates, ethylenediaminetetraacetic acid, ethylene glycol, pyrocatechol, pyrogallol, tannic acid, phosphonium salts and phosphonic acids. The ceria-based CMP slurry is believed to provide good selectivity of silicon oxide and/or silicon nitride relative to polysilicon.

The American patent application US 2007/0175104 A1 discloses a ceria-based CMP slurry comprising a polysilicon polishing inhibitor which is selected from water-soluble polymers having a N-monosubstituted or N,N-di-substituted skeleton substituted by any members selected from the group consisting of acrylamide, methacrylamide and alpha-substituted derivatives thereof; polyethylene glycols; polyvinylpyrrolidones; alkyloxylated linear aliphatic alcohols and ethyleneoxide adducts of acetylene-based diols. The ceria-based CMP slurry may contain additional water-soluble polymers such as polysaccharides like alginic acid, pectin acid, carboxymethylcellulose, agar, curdlan, and pullulan; polycarboxylic acids such as polyaspartic acid, polyglutamic acid, polylysine, polymalic acid, polymethacrylic acid, polyimide acid, polymaleic acid, polyitaconic acid, polyfumaric acid, poly(p-styrene carboxylic acid), polyacrylic acid, polyacrylamide, amino polyacrylamide, polyglyoxalic acid and their salts; and vinyl polymers such as polyvinyl alcohol, and polyacrolein. The ceria-based CMP slurry is said to have a high silicon oxide over polysilicon selectivity.

The American patent application US 2007/0191244 A1 discloses a ceria-based CMP slurry containing a compound having a weight-average molecular weight of 30 to 500 and containing hydroxyl groups and a carboxyl group or both such as citrates, malates, gluconates, tartrates, 2-hydroxyisobutyrates, adipates, octanoates, succinates, EDTA-containing compounds, glutarates, methylenesuccinates, mannose, glycero-galacto-heptose, erythro-manno-octose, arabino-galacto-nonose, and glutamine. The ceria-based CMP slurry may furthermore contain linear polymer acids or graft type polymer acids having alkoxypolyalkylene glycol side chains. The ceria-based CMP slurry is said to achieve an improved global planarity of the polished wafers.

The American patent applications US 2008/0085602 A1 and US 2008/0124913 A1 disclose a ceria-based CMP slurry containing 0.001 to 0.1% by weight of the nonionic surfactant selected from ethyleneoxide-propyleneoxide-ethyleneoxide triblock copolymers and polyacrylic acid as dispersing agent. The ceria-based slurry he said to have a high silicon oxide and silicon nitride over polysilicon selectivity.

The fabrication of electrical devices, in particular, semiconductor integrated circuits (ICs); requires high precision methods which involve inter alia high selectivity CMP.

Although the prior art ceria-based CMP slurries may have a satisfactory oxide-to-nitride selectivity and may yield polished wafers having a good global and local planarity as exemplified by the within-wafer nonuniformity (WIWNU) and the wafer-to-wafer nonuniformity (WTWNU), the ever decreasing dimensions of the IC architectures, in particular ICs with LSI (large-scale integration) or VLSI (very-large-scale integration), necessitate the constant improvement of the ceria-based CMP slurries in order to and meet the ever increasing technical and economical demands of the manufacturers of integrated circuit devices.

However, this pressing need to constantly improve the prior art ceria-based CMP slurries does not only apply to the field of integrated circuit devices, but the polishing and planarization efficacy has also to be improved in the fields of manufacturing other electrical devices such as liquid crystal panels, organic electroluminescent panels, printed circuit boards, micro machines, DNA chips, micro plants, photovoltaic cells, and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks. The manufacturing of such electrical and optical devices also requires high precision CMP process steps.

The European patent application EP 1 338 636 A1 discloses a ceria-based CMP slurry comprising an anti-solidification agent selected from the group consisting of cellulose, crystalline cellulose, cellulose derivatives, silica, alginates, beta-naphthalene sulfonate formalin condensates, calcium secondary phosphate, proteins, polypeptides and organic high-molecular flocculants, and a dispersing agent or surfactant such as a condensed phosphate like pyrophosphoric acid, sodium pyrophosphate, sodium tripolyphosphate or sodium hexametaphosphate. However, only the polishing of glass is disclosed.

The Japanese patent application JP 2005-336400 A discloses a ceria-based CMP slurry comprising a water-soluble condensed phosphate such as pyrophosphate, tripolyphosphate and hexametaphosphoric acid salt, and a water-soluble carbonate or hydrogencarbonate. The ceria-based CMP slurry may furthermore contain a water-soluble organic solvent such as methanol, ethanol, 1-propanol, 2-propanol, 1-butanol, 2-butanol, ethylene glycol, propylene glycol and 1,2,3-propanetriol, ketones such as acetone and methylethylketone, tetrahydrofurane, N,N-dimethylformamide, dimethyl sulfoxide, and 1,4-dioxane. The ceria-based CMP slurry is said to have improved polishing with regard to polishing accuracy, cleaning, initial polishing speed and polishing speed. However, only the polishing of glass is disclosed.

The Japanese patent application JP 2001-240850 A discloses a CMP slurry containing a alumina, zirconia or silicon carbide as the abrasive, an alkylene oxide-ethyleneoxide block or random copolymer as dispersing agent and sodium phosphate or sodium polyphosphate as an "anti-rust". The CMP slurry is used for polishing silicon wafers, glass, aluminum, ceramic, synthetic silica, quartz and sapphire.

### Objects of the Invention

Therefore, it is an object of the present invention to provide a novel aqueous polishing composition, in particular a novel chemical mechanical polishing (CMP) composition, especially a novel ceria-based CMP slurry, which no longer exhibits the disadvantages and drawbacks of the prior art polishing compositions.

In particular, the novel aqueous polishing composition, in particular the novel chemical mechanical polishing (CMP) composition, especially the novel ceria-based CMP slurry, should exhibit a significantly improved oxide-to-nitride selectivity and yield polished wafers having an excellent global and local planarity as exemplified by the within-wafer nonuniformity (WIWNU) and the wafer-to-wafer nonuniformity (WTWNU). Therefore, they should be excellently suited for manufacturing IC architectures, in particular ICs with LSI (large-scale integration) or VLSI (very-large-scale integration), having structures with dimensions below 50 nm.

Moreover, the novel aqueous polishing composition, in particular the novel chemical mechanical polishing (CMP) composition and especially the novel ceria-based CMP slurry should not only be exceptionally useful in the field of integrated circuit devices, but should also be most efficiently and advantageously useful in the fields of manufacturing other electrical devices such as liquid crystal panels, organic electroluminescent panels, printed circuit boards, micro machines, DNA chips, micro plants and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

It is a further object of the present invention to provide a novel process for polishing substrates for mechanical, electrical and optical devices, the said substrates containing silicon oxide dielectric and silica nitride films.

### Summary of the Invention

Accordingly, the novel aqueous polishing composition having a pH in the range of from 3 to 11 has been found, the said aqueous polishing composition comprising
(A) inorganic particles containing or consisting of ceria in an amount of from 0.01 to 6% by weight based on the complete weight of the composition (B) at least one anionic phosphate dispersing agent, characterized in that the water soluble condensed phosphate (B) is selected from the group consisting of metaphosphates of the general formula I:

   [M+n(P03)n] (I);

   and polyphosphates of the general formula II and III:

   M+nPn03n+1 (II);

   M+H2Pn0 3n+1 (III);

   wherein M is ammonium, sodium and potassium and the index n is from 2 to 10,000 and (B) is used in amounts so that a weight ratio of ceria to anionic phosphate dispersing agent
(B) of 20 to 1000 results.
(C) at least one polyhydric alcohol component selected from the group consisting of (c1) polyhydric alcohols selected from the group consisting of water-soluble and water-dispersible, aliphatic and cycloaliphatic, monomeric, dimeric and oligomeric polyols having at least 4 hydroxy groups that are not dissociable in the aqueous medium, wherein the polyhydric alcohol
   (c1) is contained in amounts of from 0.005 to 5 % by weight, based on the complete weight of the composition;
   (c2) a mixture consisting of (c21) at least one polyhydric alcohol selected from the group consisting of water-soluble and water-dispersible, aliphatic and cycloaliphatic polyols having at least 2 hydroxy groups that are not dissociable in the aqueous medium, wherein the polyol (c21) is used in amounts of from 0.05 to 5 % by weight, based on the complete weight of the composition; and (c22) at least one water-soluble or water-dispersible polymer selected from the group consisting of linear and branched alkylene oxide homopolymers, wherein the polymer (c22) is used in amounts of from 0.005 to 5 % by weight, based on the complete weight of the composition and copolymers (c221); and linear and branched, aliphatic and cycloaliphatic poly(N-vinylamide) homopolymers and copolymers (c222); and
   (c3) mixtures of (c1) and (c2).

Hereinafter, the novel aqueous polishing composition is referred to as the "composition of the invention".

Moreover, the novel process for polishing substrates for mechanical, electrical and optical devices by contacting the substrate at least once with the composition of the invention and polishing the substrate until the desired planarity is achieved, has been found.

Hereinafter, the novel process for polishing substrates for mechanical, electrical and optical devices is referred to as the "process of the invention".

Last but not least, the novel use of the composition of the invention for manufacturing electrical, mechanical and optical devices has been found, which use is hereinafter referred to as the "use of the invention".

### Advantages of the Invention

In view of the prior art, it was surprising and could not be expected by the skilled artisan that the objects of the present invention could be solved by the composition of the invention, the process and the use of the invention.

It was particularly surprising that the composition of the invention exhibited a significantly improved oxide-to-nitride selectivity and yield polished wafers having an excellent global and local planarity as exemplified by the within-wafer nonuniformity (WIWNU) and the wafer-to-wafer nonuniformity (WTWNU). Therefore, they were excellently suited for manufacturing IC architectures, in particular ICs with LSI (large-scale integration) or VLSI (very-large-scale integration), having structures with dimensions below 50 nm.

Additionally, the composition of the invention was stable during prolonged transport and storage, which stability significantly improved the logistics and the process management.

Moreover, the composition of the invention was not only exceptionally useful in the field of integrated circuit devices, but was also most efficiently and advantageously useful in the fields of manufacturing other electrical devices such as liquid crystal panels, organic electroluminescent panels, printed circuit boards, micro machines, DNA chips, micro plants and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

Most particularly, the composition of the invention was exceptionally well-suited for the use of the invention .

Therefore, the composition of the invention was most particularly useful for the process of the invention. The process of invention could be most advantageously used for polishing, in particular chemically mechanically polishing, substrates for electrical devices such as liquid crystal panels, organic electroluminescent panels, printed circuit boards, micro machines, DNA chips, micro plants and magnetic heads; as well as substrates for high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

Most particularly however, the process of the invention was excellently suited for polishing semiconductor wafers containing silicon oxide dielectric films and silica nitride films. The process of the invention yielded polished wafers having an excellent global and local planarity and balance without dishing, cupping or hotspots as exemplified by the within-wafer nonuniformity (WIWNU) and the wafer-to-wafer nonuniformity (WTWNU). Therefore, they were excellently suited for manufacturing IC architectures, in particular ICs with LSI (large-scale integration) or VLSI (very-large-scale integration), having structures with dimensions below 50 nm.

### Detailed Description of the Invention

The composition of the invention is an aqueous composition. This means that it contains water, in particular ultrapure water, as the main solvent and dispersing agent. Nevertheless, the composition of the invention may contain at least one water-miscible organic solvent, however, only in such minor amounts that they do not change the aqueous nature of the composition of the invention.

Preferably, the composition of the invention contains water in amounts of from 60 to 99.95% by weight, more preferably 70 to 99.9% by weight, even more preferably 80 to 99.9% by weight and, most preferably, 90 to 99.9% by weight, the weight percentages being based on the complete weight of the composition of the invention.

The pH of the composition of the invention is set between 3 and 11, more preferably, 4 and 11, even more preferably between 5 and 11, and, most preferably between 6 and 11 preferably using the pH-adjusting agents (E) hereinafter described.

"Water-soluble" means that the relevant component or ingredient of the composition of the invention can be dissolved in the aqueous phase on the molecular level.

"Water-dispersible" means that the relevant component or ingredient of the composition of the invention can be dispersed in the aqueous phase and forms a stable emulsion or suspension.

"Dimer" or "dimeric" means that the relevant component or ingredient of the composition of the invention consists of two linked monomeric structural units which both may have the same structure or may have structures different from each other.

"Oligomer" or "oligomer" means that the relevant component or ingredient of the composition of the invention consists of 3 to 12 linked monomeric structural units which all may have the same structure. However, it is also possible that the structural units are selected from at least two different structures.

"Polymer" or "polymeric" means that the relevant component or ingredient of the composition of the invention consists of more than 12 linked monomeric structural units which all may have the same structure. However, it is also possible that the structural units are selected from at least two different structures.

"Polyhydric" means "containing two or more hydroxy groups".

The first essential ingredient of the composition of the invention is at least one, preferably one, type of abrasive particles (A).

The abrasive particles (A) are positively charged when the dispersed in an aqueous medium which is free from the anionic phosphate dispersing agent (B) hereinafter described and has a pH in the range of from 3 to 9. The positive charge is evidenced by the electrophoretic mobility µ (µm/s) (V/cm) of the abrasive particles (A). The electrophoretic mobility µ can be directly measured with instruments such as Zetasizer Nano from Malvern, Ltd.

The average particle size of the abrasive particles (A) can vary broadly and, therefore, can be adjusted most advantageously to the particular requirements of a given composition and process of the invention. Preferably, the average particle size as determined by dynamic laser light scattering is in the range of from 1 to 2000 nm, preferably 1 to 1000 nm, more preferably 1 to 750, and, most preferably, 1 to 500 nm.

The particle size distribution of the abrasive particles (A) can be monomodal, bimodal or multimodal. Preferably, the particle size distribution is monomodal in order to have an easily reproducible property profile of the abrasive particles (A) and easily reproducible conditions during the process of the invention.

Moreover, the particle size distribution of the abrasive particles (A) can be narrow or broad. Preferably, the particle size distribution is narrow with only small amounts of small particles and large particles in order to have an easily reproducible property profile of the abrasive particles (A) and easily reproducible conditions during the process of the invention.
The abrasive particles (A) can have various shapes. Thus, they may be of one or essentially one type of shape. However, it also possible that the abrasive particles (A) have different shapes. In particular, two types of differently shaped abrasive particles (A) may be present in a given composition of the invention. As regards the shapes themselves, they can be cubes, cubes with chamfered edges, octahedrons, icosahedrons, nodules and spheres with or without protrusions or indentations. Most preferably, the shape is spherical with no or only very few protrusions or indentations. This shape, as a rule, is preferred because it usually increase is the resistance to the mechanical forces the abrasive particles (A) are exposed to it during a CMP process.

In principle, any type of abrasive particles (A) can be used in the composition of the invention as long as they possess the above described property profile. Thus, the abrasive particles (A) may be organic or inorganic particles or organic-inorganic hybrid particles. Preferably, the abrasive particles (A) are inorganic particles.

In principle, any type of inorganic abrasive particles (A) can be used in the composition of the invention as long as they possess the above described property profile. However, most preferably, inorganic abrasive particles (A) containing or consisting of ceria are used.

The abrasive particles (A) which contain ceria can contain minor amounts of other rare earth metal oxides.

Preferably, the abrasive particles (A) which contain ceria are composite particles (A) comprising a core containing or consisting of at least one other abrasive particulate material which is different from ceria, in particular alumina, silica titania, zirconia, zinc oxide, and mixtures thereof.

Such composite particles (A) are known, for example, from WO 2005/035688 A1, US 6,110,396, US 6,238,469 B1, US 6,645,265 B1, K. S. Choi et al., Mat. Res. Soc. Symp. Proc. Vol. 671, 2001 Materials Research Society, M5.8.1 to M5.8.10, S.-H. Lee et al., J. Mater. Res., Vol. 17, No. 10, (2002), pages 2744 to 2749, A. Jindal et al., Journal of the Electrochemical Society, 150 (5) G314-G318 (2003), Z. Lu, Journal of Materials Research, Vol. 18, No. 10, October 2003, Materials Research Society, or S. Hedge et al., Electrochemical and Solid-State Letters, 7 (12) G316-G318 (2004).

Most preferably, the composite particles (A) are raspberry-type coated particles comprising a core selected from the group consisting of alumina, silica titania, zirconia, zinc oxide, and mixtures thereof with a core size of from 20 to 100 nm wherein the core is coated with ceria particles having a particle size below 10 nm.

The amount of the abrasive particles (A) used in the composition of the invention can vary broadly and, therefore, can be adjusted most advantageously to the particular requirements of a given composition and process of the invention. Preferably, the composition of the invention contains 0.005 to 10% by weight, more preferably 0.01 to 8% by weight and, most preferably 0.01 to 6% by weight of the abrasive particles (A), the weight percentages being based on the complete weight of the composition of the invention.

The composition of the invention contains at least one, preferably one, anionic phosphate dispersing agent (B) as the second essential ingredient.

Preferably, the anionic phosphate dispersing agent (B) is selected from the group consisting of water-soluble condensed phosphates.

Examples for water-soluble condensed phosphates (B) are salts, in particular ammonium, sodium and potassium salts, of metaphosphates of the general formula I:

[M⁺ₙ(PO₃)ₙ] (I);

and polyphosphates of the general formula II and III:

M⁺ₙPₙO₃ₙ₊₁ (II);

M⁺H₂PₙO₃ₙ₊₁ (III);

wherein M is ammonium, sodium and potassium and the index n is from 2 to 10,000. Regarding the polyphosphates of formulas I, II, and III, the index n is preferably from 2 to 2,000, more preferably from 2 to 300, most preferably from 2 to 50, particularly from 2 to 15, for example from 3 to 8.

Examples for particularly suitable water-soluble condensed phosphates (B) are Graham's salt (NaPO₃)₄₀₋₅₀, Calgon™(NaPO₃)₁₅₋₂₀, Kurrol's salt (NaPO₃)ₙ with n = about 5000, and ammonium, sodium and potassium hexametaphosphate.

The concentration of the water-soluble anionic phosphate dispersing agent (B) in the composition of the invention can vary broadly and, therefore, can be adjusted most advantageously to the particular requirements of a given composition and process of the invention. Preferably, the anionic phosphate dispersing agents (B) is used in amounts so that a weight ratio of ceria to anionic phosphate dispersing agent (B) of 10 to 2000 and, more preferably, 20 to 1000 results.

As the third essentially ingredient, the composition of the invention contains at least one, preferably one, poyhydric alcohol component (C).

The polyhydric alcohol component (C) is selected from the group consisting of
(c1) polyhydric alcohols selected from the group consisting of water-soluble and water-dispersible, preferably water-soluble, aliphatic and cycloaliphatic, monomeric, dimeric and oligomeric polyols having at least 4, preferably at least 5 and, most preferably at least 6 hydroxy groups to the molecule, the said hydroxy groups not being dissociable in the aqueous medium;
(c2) a mixture consisting of
   (c21) at least one, preferably one, polyhydric alcohol selected from the group consisting of water-soluble and water-dispersible, preferably water-soluble, aliphatic and cycloaliphatic polyols having at least 2, preferably 2 or 3 hydroxy groups to the molecule, the said hydroxy groups not being dissociable in the aqueous medium; and
   (c22) at least one, preferably one, water-soluble or water-dispersible, preferably water-soluble, polymer selected from the group consisting of linear and branched alkylene oxide homopolymers and copolymers (c221); and linear and branched, aliphatic and cycloaliphatic poly(N-vinylamide) homopolymers and copolymers (c222); and
(c3) mixtures of (c1) and (c2).

"Not dissociable" means that the dissociation constant for the reaction R-OH → R-O⁻ + H⁺ of the hydroxy group in the neutral aqueous phase is very low or, for practical purposes, virtually zero.

Preferably, the poyhydric alcohol (c1) is selected from the group consisting of pentaerythritol, alditols, cyclitols, carbohydrates and dimers and oligomers of glycerol, trimethylolpropane, pentaerythritol, alditols and cyclitols.

Preferably, the alditol (c1) is selected from the group consisting of tetritols, pentitols, hexitols, heptitols, and octitols.

More preferably, the tetritol (c1) is selected from erythritol, threitol and mixtures thereof; the pentitol (c1) is selected from the group consisting of arabinitol, ribitol, xylitol and mixtures thereof; the hexitol (c1) is selected from the group consisting of galactitol, mannitol, glucitol, allitol, altritol, iditol and mixtures thereof.

Preferably, the dimer (c1) is selected from the group consisting of the dimers of glycerol, trimethylolpropane, erythritol, threitol and pentaerythritol and mixtures thereof as well as maltitol, isomalt, lactitol and mixtures thereof.

More preferably, oligomer (c1) is selected from the group consisting of tri-, tetra-, penta-, hexa-, hepta-, octa-, nona-, deca-, undeca- and dodecaglycerol, -trimethylolpropane, -erythritol, - threitol and -pentaerythritol and mixtures thereof.
Preferably, the cyclitols (c1) are selected from 1,2,3,4-tetrahydroxycyclohexane, 1,2,3,4,5-pentahydroxycyclohexane, inositols and mixtures thereof.

More preferably, the inositol (c1) is selected from the group consisting of myo-, scyllo-, muco-, chiro-, neo-, allo-, epi- and cis-inositol and mixtures thereof. Most preferably, myo-inositol (c1) is used.

Preferably, the carbohydrate (c1) is selected from the group consisting of monosaccharides, disaccharides, oligosaccharides, polysaccharides, desoxy sugars and amino sugars, in particular, monosaccharides (c1).

Preferably, the monosaccharide (c1) is selected from the group consisting of allose, altrose, glucose, mannose, idose, galactose and talose, in particular galactose

The concentration of the polyhydric alcohol (c1) in the composition of the invention can vary broadly and, therefore, can be most advantageously adapted to the particular requirements of a given composition and process of the invention. Preferably, the composition of the invention contains the polyhydric alcohol (c1) in amounts of from to 0.005 is to 5% by weight, more preferably 0.01 to 4% by weight, and most preferably 0.05 to 3% by weight, the weight percentages being based on the complete weight of the composition of the invention.

Preferably, the water-soluble or water-dispersible, aliphatic or cycloaliphatic polyol (c21) having 2 to 3 hydroxy groups that are not dissociable in the aqueous medium is selected from the group consisting of ethylene glycol, propylene glycol, diethylene glycol, triethylene glycol, dipropylene glycol, tripropylene glycol, ethylene propylene glycol, diethylene propylene glycol, ethylene dipropylene glycol, glycerol, 1,2,3-trihydroxy-n-butane, trimethylolpropane, and mixtures thereof, most preferably, ethylene glycol, glycerol and mixtures thereof.

The concentration of the polyol (c21) in the composition of the invention can also vary broadly and, therefore, can be adapted most advantageously to the particular requirements of a given composition and process of the invention. Preferably, the polyol (c21) is used in amounts of from 0.05 to 5% by weight, preferably 0.1 to 4% by weight, and most preferably 0.5 to 3% by weight, the weight percentages being based on the complete weight of the composition of the invention.

Preferably, the alkylene oxide homopolymer or copolymer (c221) is selected from the group consisting of linear and branched ethyleneoxide and propyleneoxide homopolymers and copolymers.

The ethyleneoxide-propyleneoxide copolymers (c221) can be random copolymers, alternating copolymers or blockcopolymers containing polyethyleneoxide blocks and polypropyleneoxide blocks. In the ethyleneoxide-propyleneoxide blockcopolymers (c221), the polyethyleneoxide blocks preferably have hydrophile-lipophile-balance (HLB) values from 10 to 15. The polypropyleneoxide blocks may preferably have a HLB values of from 28 to about 32.

Preferably, the alkylene oxide homopolymers (c221) are ethyleneoxide polymers, such as polyethylene glycol (PEG).

Preferably, the water-soluble polymers (c221) have a weight average molecular weight of from 2000 to 1,000,000 Dalton, more preferably 5000 to 500,000 Dalton and, most preferably, 10,000 to 250,000 Dalton.

The water-soluble polymers (c221) are customary and known, commercially available materials. Suitable water-soluble polymers (c22) are described in the Japanese patent application JP 2001-240850 A, claim 2 in conjunction with the paragraphs [0007] to [0014], the American patent application US 2007/0077865 A1, column page 1, paragraph [0008] to page 2, paragraph [0010], the American patent application US 2006/0124594 A1, page 3, paragraphs [0036] and [0037] and the American patent application US 2008/0124913 A1, page 3, paragraphs [0031] to [0033] in conjunction with the claim 14 or they are sold under the trademarks Pluronic™, Tetronic™ and Basensol™ by BASF Corporation and BASF SE as evidenced by the company brochure of BASF Corporation "Pluronic™ & Tetronic™ Block Copolymer Surfactants, 1996" or the American patent US 2006/0213780 A1.

Most preferably, polyethylene glycol (PEG) is used as the polymer (c221).

The composition of the invention can also comprise the polymer (c221) in combination with the polyhydric alcohol (c1) only.

Also the concentration of the polymer (c221) in the composition of the invention can vary broadly and, therefore, can be adapted most advantageously to the particular requirements of a given composition and process of the invention. Preferably, the polymer (c22) is used in amounts of from 0.005 to 5% by weight, preferably 0.01 to 4% by weight, and most preferably 0.05 to 3% by weight, the weight percentages being based on the complete weight of the composition of the invention.

Preferably, the aliphatic and cycloaliphatic N-vinylamide monomers, which are the building blocks of the linear and branched, aliphatic and cycloaliphatic poly(N-vinylamide) homopolymers and copolymers (c222), are selected from the group consisting of N-vinylacetamide, N-vinylpyrrolidone, N-vinylvalerolactam, N-vinylcaprolactam, N-vinylsuccinimide and mixtures thereof.

The poly(N-vinylamide) copolymers (c222) may contain monomeric units derived from customary and known olefinically unsaturated monomers other than the N-vinylamides, as for example, vinyl esters and ethers, acrylic and methacrylic esters, allylic esters and ethers, olefins which may be substituted by halogen atoms or nitrile groups, and styrenic monomers, provided that such monomeric units are only contained in such amounts that the water-solubility is not jeopardized.

Preferably, the water-soluble polymers (c222) have a weight average molecular weight of from 2000 to 1,000,000 Dalton, more preferably 5000 to 500,000 Dalton and, most preferably, 10,000 to 250,000 Dalton.

The composition of the invention can also comprise the polymer (c222) in combination with the polyhydric alcohol (c1) only.

Likewise, the concentration of the polymer (c222) in the composition of the invention can vary broadly and, therefore, can be adapted most advantageously to the particular requirements of a given composition and process of the invention. Preferably, the polymer (c22) is used in amounts of from 0.005 to 5% by weight, preferably 0.01 to 4% by weight, and most preferably 0.05 to 3% by weight, the weight percentages being based on the complete weight of the composition of the invention.

In the composition of the invention, also weight ratio of poyhydric alcohol (c1) to mixture (c2) can vary broadly and, therefore, can be adapted most advantageously to the particular requirements of a given composition and process of the invention. Preferably, the weight ratio (c1):(c2) is in the range of from 100:1 to 1:100.

Moreover, in the composition of the invention, also weight ratio of poyhydric alcohol (c21) to polymer (c221) or (c222) can vary broadly and, therefore, can be adapted most advantageously to the particular requirements of a given composition and process of the invention. Preferably, the weight ratio (c21):(c221) or (c222) is in the range of from 100:1 to 1:100.

The composition of the invention can optionally contain at least one functional component (D) which is materially different from the ingredients (A), (B) and (C).

Preferably, the functional component (D) is selected from the group of compounds customarily used in ceria-based CMP slurries.

Examples of such compounds (D) are disclosed in, for example, by Y. N. Prasad et al. in Electrochemical and Solid-State Letters, 9 (12) G337-G339 (2006), Hyun-Goo Kang et al. in Journal of Material Research, volume 22, No.3, 2007, pages 777 to 787, S. Kim et al. in Journal of Colloid and Interface Science, 319 (2008), pages 48 to 52, S. V. Babu et al. in Electrochemical and Solid-State Letters, 7 (12) G327-G330 (2004), Jae-Dong Lee et al. in Journal of the Electrochemical Society, 149 (8) G477-G481, 2002, the American patents US 5,738,800, US 6, 042, 741, US 6,132,637, US 6,218,305 B, US 5,759,917, US 6,689,692 B1, US 6,984,588 B2, US 6,299,659 B1, US 6,626,968 B2, US 6,436,835, B1 US 6,491,843 B1, US 6,544,892 B2, US 6,627,107 B2, US 6,616,514 B1, and US 7,071,105 B2, the American patent applications US 2002/0034875 A1, US 2006/0144824 A1, US 2006/0207188 A1, US 2006/0216935 A1, US 2007/0077865 A1, US 2007/0175104 A1, US 2007/0191244 A1 and US 2007/0218811 A1, and the Japanese patent application JP 2005-336400 A.

Moreover, the functional component (D) is selected from the group consisting of organic, inorganic and hybrid organic-inorganic abrasive particles being different from the particles (D), materials having a lower critical solution temperature LCST or an upper critical solution temperature UCST, oxidizing agents, passivating agents, charge reversal agents, complexing or chelating agents, frictive agents, stabilizing agents, rheology agents, surfactants, biocides, metal cations, and organic solvents.

Suitable organic abrasive particles (D) and their effective amounts are known, for example, from the American patent application US 2008/0254628 A1, page 4, paragraph [0054] or from the international application WO 2005/014753 A1, wherein solid particles consisting of melamine and melamine derivatives such as acetoguanamine, benzoguanamine and dicyandiamide are disclosed.

Suitable inorganic abrasive particles (D) and their effective amounts are known, for example, from the international patent application WO 2005/014753 A1, page 12, lines 1 to 8 or the American patent US 6,068,787, column 6, line 41 to column 7, line 65.

Suitable hybrid organic-inorganic abrasive particles (D) and their effective amounts are known, for example, from the American patent applications US 2008/0254628 A1, page 4, paragraph [0054] or US 2009/0013609 A1, page 3, paragraph [0047] to page 6, paragraph [0087].

Suitable oxidizing agents (D) and their effective amounts are known, for example, from the European patent application EP 1 036 836 A1, page 8, paragraphs [0074] and [0075] or from the American patents US 6,068,787, column 4, line 40 to column 7, line 45 or US 7,300,601 B2, column 4, lines 18 to 34. Preferably, organic and inorganic peroxides, more preferably inorganic peroxides, are used. In particular, hydrogen peroxide is used.

Suitable passivating agents (D) and their effective amounts are known, for example, from the American patent US 7,300,601 B2, column 3, line 59 to column 4, line 9 or from the American patent application US 2008/0254628 A1, the paragraph [0058] bridging the pages 4 and 5.

Suitable complexing or chelating agents (D), which are sometimes also designated as frictive agents (cf. the American patent application US 2008/0254628 A1, page 5, paragraph [0061]) or etching agents or etchants (cf. the American patent application US 2008/0254628 A1, page 4, paragrap [0054]), and their effective amounts are known, for example, from the American patent US 7,300,601 B2, column 4, lines with 35 to 48. The amino acids, in particular glycine, and, moreover, dicyandiamide and triazines containing at least one, preferably two and, more preferably, three primary amino groups such as melamine and water-soluble guanamines, particularly melamine, formoguanamine, acetoguanamine and 2,4-diamino-6-ethyl-1,3,5-triazine, are most particularly preferably used.

Suitable stabilizing agents (D) and their effective amounts are known, for example, from the American patent US 6,068,787, column 8, lines 4 to 56.

Suitable rheology agents (D) and their effective amounts are known, for example, from the American patent application US 2008/0254628 A1, page 5, paragraph [0065] to page 6, paragraph [0069].

Suitable surfactants (D) and their effective amounts are known, for example, from the international patent application WO 2005/014753 A1, page 8, line 23, to page 10, line 17 or from the American patent US 7,300,601 B2, column 5, line 4 to column 6, line 8.

Suitable polyvalent metal ions (D) and their effective amounts are known, for example, from the European patent application EP 1 036 836 A1, page 8, paragraph [0076] to page 9, paragraph [0078].

Suitable organic solvents (D) and their effective amounts are known, for example, from the American patent US 7,361,603 B2, column 7, lines 32 to 48 or the American patent application US 2008/0254628 A1, page 5, paragraph [0059].

Suitable materials (D) exhibiting a lower critical solution temperature LCST or an upper critical solution temperature UCST are described, for example, in the article of H. Mori, H. Iwaya, A. Nagai and T. Endo, Controlled synthesis of thermoresponsive polymers derived from L-proline via RAFT polymerization, in Chemical Communication, 2005, 4872-4874; or in the article of D. Schmaljohann, Thermo- and pH-responsive polymers and drug delivery, Advanced Drug Delivery Reviews, volume 58 (2006), 1655-1670 or in the American patent applications US 2002/0198328 A1, US 2004/0209095 A1, US 2004/0217009 A1, US 2006/0141254 A1, US 2007/0029198 A1, US 2007/0289875 A1, US 2008/0249210 A1, US 2008/0050435 A1 or US 2009/0013609 A1, the American patents US 5,057,560, US 5,788,82 and US6,682,642 B2, the international patent applications WO 01/60926 A1, WO2004/029160 A1, WO 2004/0521946 A1, WO 2006/093242 A2 or WO 2007/012763 A1, in the European patent applications EP 0 583 814 A1, EP 1 197 587 B1 and EP 1 942 179 A1, or the German patent application DE 26 10 705.

In principle, any known charge reversal agent (D) customarily used in the field of CMP can be used. Preferably, the charge reversal agent (D) is selected from the group consisting of monomeric, oligomeric and polymeric compounds containing at least one anionic group selected from the group consisting of carboxylate, sulfonate, sulfate and phosphonate groups.

Suitable biocides (D) can be selected from the group consisting of water-soluble or water-dispersible N-substituted diazenium dioxides and N'-hydroxy-diazenium oxide salts.

If present, the functional component (D) can be contained in varying amounts. Preferably, the total amount of (D) is not more than 10 wt.% ("wt.%" means "percent by weight"), more preferably not more than 2 wt.%, most preferably not more than 0.5 wt.%, particularly not more than 0.1 wt.%, for example not more than 0.01 wt.%, based on the total weight of the corresponding CMP composition. Preferably, the total amount of (D) is at least 0.0001 wt.%, more preferably at least 0.001 wt.%, most preferably at least 0.008 wt.%, particularly at least 0.05 wt.%, for example at least 0.3 wt.%, based on the total weight of the corresponding composition.

The composition of the invention can optionally contain at least one pH-adjusting agent or buffering agent (E) which is materially different from the ingredients (A), (B) and (C).

Suitable pH-adjusting agents or buffering agents (E) and their effective amounts are known, for example, from the European patent application EP 1 036 836 A1, page 8, paragraphs [0080], [0085] and [0086], the international patent application WO 2005/014753 A1, page 12, lines 19 to 24, the American patent application US 2008/0254628 A1, page 6, paragraph [0073] or the American patent US 7,300,601 B2, column 5, lines 33 to 63. Examples for pH-adjusting agents or buffering agents (E) are potassium hydroxide, ammonium hydroxide, tetramethylammonium hydroxide (TMAH), nitric acid, and sulfuric acid.

If present, the pH-adjusting agent or buffering agent (E) can be contained in varying amounts. Preferably, the total amount of (E) is not more than 20 wt.%, more preferably not more than 7 wt.%, most preferably not more than 2 wt.%, particularly not more than 0.5 wt.%, for example not more than 0.1 wt.%, based on the total weight of the corresponding CMP composition. Preferably, the total amount of (E) is at least 0.001 wt.%, more preferably at least 0.01 wt.%, most preferably at least 0.05 wt.%, particularly at least 0.1 wt.%, for example at least 0.5 wt.%, based on the total weight of the corresponding composition.

The preparation of the composition of the invention does not exhibit any particularities but can be carried out by dissolving or dispersing the above-described ingredients (A), (B) and (C) and optionally (D) and/or (E) in an aqueous medium, in particular, de-ionized water. For this purpose, the customary and standard mixing processes and mixing apparatuses such as agitated vessels, in-line dissolvers, high shear impellers, ultrasonic mixers, homogenizer nozzles or counterflow mixers, can be used. Preferably, the composition of the invention thus obtained can be filtered through filters of the appropriate mesh aperture, in order to remove coarse-grained particles such as the agglomerates or aggregates of the solid, finely dispersed abrasive particles (A).

The compositions of the invention are excellently suited for the process of the invention.

In the process of the invention, a substrate for electrical, mechanical and optical devices, in particular, electrical devices, most preferably, integrated circuit devices, is contacted at least once with a composition of the invention and polished, in particular, chemically and mechanically polished, until the desired planarity is achieved.

The process on the invention exhibits its particular advantages in the CMP of silicon semiconductor wafers having isolating layers consisting of low-k or ultra-low-k silicon oxide materials and silicon nitride layers as stopping or barrier layers.

Suitable low-k or ultra-low-k materials and suitable methods of preparing the insulating dielectric layers are described in, for example, the American patent applications US 2005/0176259 A1, page 2, paragraphs [0025] to [0027], US 2005/0014667 A1, page 1, paragraph [0003], US 2005/0266683 A1, page 1, paragraph [0003] and page 2, paragraph [0024] or US 2008/0280452 A1, paragraphs [0024] to [0026] or in the American patent US 7,250,391 B2, column 1, lines 49 to 54 or in the European patent application EP 1 306 415 A2, page 4, paragraph [0031].

The process of the invention is particularly suited for the shallow trench isolation (STI) which requires the selective removal of silicon dioxide over silicon nitride on a patterned wafer substrate. In this process, etched trenches are overfilled with the dielectric material, e.g., silicon dioxide, which is polished using the silicon nitride barrier film as the stopping layer. In this preferred embodiment, the process of the invention ends with clearing the silicon dioxide from the barrier film while minimizing the removal of exposed silicon nitride and trench silicon oxide.

Thus, the process of the invention exhibits an oxide-to-nitride selectivity greater than 50, preferably greater than 75 and most preferably greater than 100.

The process of the invention exhibits no particularities but can be carried out with the processes and the equipment customarily used for the CMP in the fabrication of semiconductor wafers with ICs.

As is known in the art, a typical equipment for the CMP consists of a rotating platen which is covered with a polishing pad. The wafer is mounted on a carrier or chuck with its upper side down facing the polishing pad. The carrier secures the wafer in the horizontal position. This particular arrangement of polishing and holding device is also known as the hard-platen design. The carrier may retain a carrier pad which lies between the retaining surface of the carrier and the surface of the wafer which is not being polished. This pad can operate as a cushion for the wafer.

Below the carrier, the larger diameter platen is also generally horizontally positioned and presents a surface parallel to that of the wafer to be polished. Its polishing pad contacts the wafer surface during the planarization process. During the CMP process of the invention, the composition of the invention is applied onto the polishing pad as a continuous stream or in dropwise fashion.

Both the carrier and the platen are caused to rotate around their respective shafts extending perpendicular from the carrier and the platen. The rotating carrier shaft may remain fixed in position relative to the rotating platen or may oscillate horizontally relative to the platen. The direction of rotation of the carrier typically, though not necessarily, is the same as that of the platen. The speeds of rotation for the carrier and the platen are generally, though not necessarily, set at different values.

Customarily, the temperature of the platen is set at temperatures between 10 and 70°C.

For further details reference is made to the international patent application WO 2004/063301 A1, in particular page 16, paragraph [0036] to page 18, paragraph [0040] in conjunction with the figure 1.

By way of the process of the invention semiconductor wafers with ICs comprising patterned low-k and ultra-low-k material layers, in particular silicon dioxide layers, having an excellent planarity can be obtained. Therefore, copper damascene patterns can be obtained which also have an excellent planarity and, in the finished, IC an excellent electrical functionality.

### Examples and Comparative Experiments

### Comparative Experiments C1 to C6

### The Preparation of the Comparative Aqueous Polishing Compositions C1 to C6

For the preparation of the comparative aqueous polishing compositions C1 to C6, ceria (average particle size d₅₀ 120 to 140 nm as determined by dynamic laser light scattering), sodium hexametaphosphate (PP; weight ratio of ceria to PP = 200, hereinafter designated as PP₂₀₀; weight ratio ceria to PP = 300, hereinafter referred to as PP₃₀₀) and inositol were dispersed or dissolved in ultrapure water. The amounts used are compiled in the Table 1.

**Table 1: The Compositions of the Comparative Aqueous Polishing Compositions C1 to C6**

| Composition No. | Ceria/% by weight | PP₂₀₀ | PP₃₀₀ | Inositol/% by weight | pH |
|---|---|---|---|---|---|
| C1 | 0.5 | - | - | - | 5 |
| C2 | 0.5 | + | - | - | 6.5 |
| C3 | 0.15 | - | - | - | 5 |
| C4 | 0.15 | - | - | 1 | 5 |
| C5 | 0.125 | - | - | - | 5 |
| C6 | 0.125 | - | + | - | 6 |

### Examples 1 to 11

### The Preparation of the Aqueous Polishing Compositions 1 to 11

For the preparation of the aqueous polishing compositions 1 to 11, ceria (average particle size d₅₀ 120 to 140 nm as determined by dynamic laser light scattering), sodium hexametaphosphate (PP; weight ratio of ceria to PP = 200, hereinafter designated as PP₂₀₀; weight ratio ceria to PP = 300, hereinafter referred to as PP₃₀₀) and inositol were dispersed or dissolved in ultrapure water. The amounts used are compiled in the Table 2.

**Table 2: The Compositions of the Aqueous Polishing Compositions 1 to 11**

| Composition No. | Ceria/% by weight | PP₂₀₀ | PP₃₀₀ | Inositol/% by weight | pH |
|---|---|---|---|---|---|
| 1 | 0.125 | + | - | 1 | 6.5 |
| 2 | 0.125 | - | + | 0.05 | 6 |
| 3 | 0.125 | - | + | 0.1 | 6 |
| 4 | 0.125 | - | + | 0.2 | 6 |
| 5 | 0.125 | - | + | 0.5 | 6 |
| 6 | 0.125 | - | + | 0.8 | 6 |
| 7 | 0.125 | - | + | 1 | 6 |
| 8 | 0.125 | - | + | 2 | 6 |
| 9 | 0.125 | - | + | 2 | 4 |
| 10 | 0.125 | - | + | 2 | 6 |
| 11 | 0.125 | - | + | 2 | 9 |

The aqueous polishing compositions 1 to 11 of the examples 1 to 11 were excellently suited for chemically mechanically polishing substrates for electrical, mechanical and optical devices.

### Examples 12 to 22 and Comparative Examples C7 to C12

### CMP of Silicon Dioxide Coated Blanket Wafers and Silicon Nitride Coated Blanket Wafers and Oxide-To-Nitride Selectivity

Table 3 shows which aqueous polishing compositions were used for the examples 12 to 22 and the comparative experiments C7 to C12.

**Table 3: The Aqueous Polishing Compositions and Type of Silicon Dioxide Layer Used for the Examples 12 to 22 and the Comparative Experiments C7 to C12**

| Aqueous Polishing Composition No. | Of Example or Comparative Experiment No. | Used for Example or Comparative Experiment No. | Type of Silicon Dioxide Layer Used |
|---|---|---|---|
| C1 | C1 | C7 | HDP |
| C2 | C2 | C8 | HDP |
| C3 | C3 | C9 | HDP |
| C4 | C4 | C10 | HDP |
| C5 | C5 | C11 | HDP |
| C6 | C6 | C12 | HDP |
| 1 | 1 | 12 | HDP |
| 2 | 2 | 13 | HDP |
| 3 | 3 | 14 | HDP |
| 4 | 4 | 15 | HDP |
| 5 | 5 | 16 | HDP |
| 6 | 6 | 17 | HDP |
| 7 | 7 | 18 | HDP |
| 8 | 8 | 19 | HDP |
| 9 | 9 | 20 | TEOS |
| 10 | 10 | 21 | TEOS |
| 11 | 11 | 22 | TEOS |

| | | | |
|---|---|---|---|
| HDP: High density plasma silicon doxide; TEOS: Tetraethyl orthosilicate CVD type oxide | | | |

Hereinafter, the CMP the following process parameters were used.

### Example 12 and comparative experiments C7 to C10:

- Polishing apparatus:Strasbaugh 6EGnHance (rotary type):
- platen speed: 93 rpm;
- carrier speed: 87 rpm;
- IC 1000/Suba 400 K-groove polishing pad manufactured by Rohm & Haas;
- in situ conditioning using S60 3M diamond conditioner;
- slurry flow rate: 200 ml/min;
- substrates: silicon dioxide blanket wafers (cf. Table 3) and 500 nm CVD silicon nitride blanket wafers from Montco Silicon;
- down force: 2.7 psi (185.143 mbar); C9: 1.5 psi (102.86 mbar);
- polishing time: 1 minute.

### Examples 13 to 22 and comparative experiments C11 and C12:

- Polishing apparatus: AMAT Mirra (rotary type):
- platen speed: 100 rpm;
- carrier speed: 90 rpm;
- IC 1000/Suba 400 K-groove polishing pad manufactured by Rohm & Haas;
- in situ conditioning using S60 3M diamond conditioner;
- slurry flow rate: 200 ml/min;
- substrates: silicon dioxide coated blanket wafers (cf. Table 3) and 500 nm silicon nitride coated blanket wafers;
- down force: 2 psi (137.143 mbar);
- polishing time: 1 minute.

The material removal rates (MRRs) were measured by laser interferometry (FilmTek™ 2000). The Table 4 gives an overview over the MRRs obtained.

**Table 4: CMP of Silicon Dioxide Coated Blanket Wafers and Silicon Nitride Coated Blanket Wafers and Oxide-To-Nitride Selectivity**

| Example or Comparative Experiment No. | Silicon Dioxide MRR | Silicon Nitride MRR | Oxide-To-Nitride Selectivity |
|---|---|---|---|
| | (Å/min) | (Å/min) | |
| C7 | 2378 | 589 | 4 |
| C8 | 1467 | 397 | 3.7 |
| C9 | 1971 | 331 | 6 |
| C10 | 2088 | 138 | 15 |
| C11 | 1846 | 347 | 5 |
| C12 | 1017 | 242 | 4 |
| 12 | 1430 | 63 | 22.7 |
| 13 | 1031 | 199 | 5 |
| 14 | 1107 | 120 | 9 |
| 15 | 1014 | 72 | 14 |
| 16 | 1186 | 40 | 30 |
| 17 | 1247 | 38 | 33 |
| 18 | 1220 | 30 | 41 |
| 19 | 1200 | 23 | 52 |
| 20 | 1135 | 98 | 12 |
| 21 | 1568 | 25 | 63 |
| 22 | 1342 | 21 | 64 |

The results compiled in the Table for make apparent that high oxide-to-nitride selectivities could not be achieved with aqueous polishing compositions containing ceria, ceria and PP and ceria and inositol only. Contrary to this, it was easily possible to achieve high oxide-to-nitride selectivities even greater than 50 with the polishing compositions containing ceria, PP and inositol. When the pH of the polishing composition was increased to 9, the oxide-to-nitride selectivity could be even more improved.

Such high oxide-to-nitride selectivities could also be achieved with aqueous polishing compositions containing ceria, sodium hexametaphosphate PP, glycerol and polyethylene glycol PEG and/or polyvinylpyrrolidone PVP.

### Examples 23 to 26

### The Preparation of the Aqueous Polishing Compositions 12 to 15

For the preparation of the aqueous polishing compositions 12 to 15, ceria (average particle size d₅₀ 120 to 140 nm as determined by dynamic laser light scattering), sodium hexametaphosphate (PP; weight ratio of ceria to PP = 250, hereinafter designated as PP₂₅₀), inositol, galactose and Protectol KD (N'-hydroxy-diazenium oxide salt; biocide from BASF SE) were dispersed or dissolved in ultrapure water. The amounts used are compiled in the Table 2.

**Table 5: The Compositions of the Aqueous Polishing Compositions 1 to 11 of the Examples 23 to 26**

| Ex. | Composition | Ceria/% by weight | Protectol KD/ppm | PP₂₅₀ | Inositol/% by weight | Galactose/% by weight | pH |
|---|---|---|---|---|---|---|---|
| No. | No. | | | | | | |
| 23 | 12 | 0.125 | 25 | + | - | 0.25 | 9.5 |
| 24 | 13 | 0.125 | 25 | + | 0.25 | 0.25 | 9.5 |
| 25 | 14 | 0.5 | 12.5 | + | 0.5 | - | 9.5 |
| 26 | 15 | 0.5 | 12.5 | + | 0.25 | 0.25 | 9.5 |

The aqueous polishing compositions 12 to 15 of the examples 23 to 26 were excellently suited for chemically mechanically polishing substrates for electrical, mechanical and optical devices.

### Examples 27 to 30

### CMP of Silicon Dioxide Coated Blanket Wafers and Silicon Nitride Coated Blanket Wafers and Oxide-To-Nitride Selectivity

The CMP was carried out as described in the examples 13 to 22 only that the platen speed was set at 63 rpm and the carrier speed at 60 rpm. The obtained MRRs are compiled in the Table 6.

**Table 6: CMP of Silicon Dioxide Coated Blanket Wafers and Silicon Nitride Coated Blanket Wafers and Oxide-To-Nitride Selectivity**

| Aqueous Polishing Composition | Of Example | Used for Example | TEOS MRR | Silicon Nitride MRR | Oxide-To-Nitride Selectivity |
|---|---|---|---|---|---|
| No. | No. | No. | (Å/min) | (Å/min) | |
| 12 | 23 | 27 | 1172 | 8 | 146.5 |
| 13 | 24 | 28 | 1226 | 3 | 408.6 |
| 14 | 25 | 29 | 1727 | 23 | 75 |
| 14 | 26 | 30 | 1488 | 15 | 100 |

The results of the Table 6 make apparent that the already high oxide-to- nitride selectivity achieved by the use of a cyclitol (cf. example 25) or a monosaccharide (cf. example 27) could be even more enhanced by the joint use of the cyclitol and the monosaccharide (cf. examples 28 and 30).

## Claims

1. An aqueous polishing composition having a pH in the range of from 3 to 11 and comprising
(A) inorganic particles containing or consisting of ceria in an amount of from 0.01 to 6% by weight based on the complete weight of the composition
(B) at least one anionic phosphate dispersing agent, **characterized in that** the water-soluble condensed phosphate (B) is selected from the group consisting of metaphosphates of the general formula I:
[M⁺ₙ(PO₃)ₙ] (I);
and polyphosphates of the general formula II and III:
M⁺ₙPₙO₃ₙ₊₁ (II);
M⁺H₂PₙO₃ₙ₊₁ (III);
wherein M is ammonium, sodium and potassium and the index n is from 2 to 10,000 and (B) is used in amounts so that a weight ratio of ceria to anionic phosphate dispersing agent (B) of 20 to 1000 results.
(C) at least one polyhydric alcohol component selected from the group consisting of
(c1) polyhydric alcohols selected from the group consisting of water-soluble and water-dispersible, aliphatic and cycloaliphatic, monomeric, dimeric and oligomeric polyols having at least 4 hydroxy groups that are not dissociable in the aqueous medium, wherein the polyhydric alcohol (c1) is contained in amounts of from 0.005 to 5 % by weight, based on the complete weight of the composition;
(c2) a mixture consisting of
(c21) at least one polyhydric alcohol selected from the group consisting of water-soluble and water-dispersible, aliphatic and cycloaliphatic polyols having at least 2 hydroxy groups that are not dissociable in the aqueous medium, wherein the polyol (c21) is used in amounts of from 0.05 to 5 % by weight, based on the complete weight of the composition; and
(c22) at least one water-soluble or water-dispersible polymer selected from the group consisting of linear and branched alkylene oxide homopolymers, wherein the polymer (c22) is used in amounts of from 0.005 to 5 % by weight, based on the complete weight of the composition and copolymers (c221); and linear and branched, aliphatic and cycloaliphatic poly(N-vinylamide) homopolymers and copolymers (c222); and
(c3) mixtures of (c1) and (c2).

2. The aqueous polishing composition according to claim 1, **characterized in that** the water-soluble and water-dispersible, aliphatic and cycloaliphatic, monomeric, dimeric and oligomeric polyols (c1) having at least 4 hydroxy groups that are not dissociable in the aqueous medium are selected from the group consisting erythritol, pentaerythritol, alditols, cyclitols, carbohydrates and dimers and oligomers of glycerol, erythritol, pentaerythritol, alditols, cyclitols.

3. The aqueous polishing composition according to claim 2, **characterized in that** the alditol (c1) is selected from the group consisting of tetritols, pentitols, hexitols, heptitols, and octitols; the cyclitol (c1) is selected from inositols; and the carbohydrate (c1) is selected from the group consisting of monosaccharides, disaccharides, oligosaccharides, polysaccharides, desoxy sugars and amino sugars.

4. The aqueous polishing composition according to claim 3, **characterized in that** the monosaccharide (c1) is selected from the group consisting of allose, altrose, glucose, mannose, idose, galactose and talose.

5. The aqueous polishing composition according to anyone of the claims 1 to 4, **characterized in that** the water-soluble or water-dispersible, aliphatic or cycloaliphatic polyol (c21) having 2 to 3 hydroxy groups that are not dissociable in the aqueous medium is selected from the group consisting of ethylene glycol, propylene glycol, diethylene glycol, triethylene glycol, dipropylene glycol, tripropylene glycol, ethylene propylene glycol, diethylene propylene glycol, ethylene dipropylene glycol, glycerol, 1,2,3-trihydroxy-n-butane, trimethylolpropane, and mixtures thereof; **in that** the water-soluble or water-dispersible, linear or branched alkylene oxide homopolymer or copolymer (c221) is selected from the group consisting of ethyleneoxide and propyleneoxide homopolymers and copolymers; and that the linear or branched, aliphatic or cycloaliphatic poly(N-vinylamide) homopolymer or copolymer (c222) is selected from the group consisting of homopolymers and copolymers of aliphatic and cycloaliphatic N-vinylamide monomers selected from the group consisting of N-vinylacetamide, N-vinylpyrrolidone, N-vinylvalerolactam, N-vinylcaprolactam, N-vinylsuccinimide and mixtures thereof.

6. The aqueous polishing composition according to anyone of the claims 1 to 5, **characterized in that** it contains at least one pH-adjusting agent or buffering agent (E) different from the components (A), (B) and (C).

7. The aqueous polishing composition according to anyone of the claims 1 to 6, **characterized in that** it contains at least one functional component (D) different from the components (A), (B) and (C), and the functional component (D) is selected from the group consisting of organic, inorganic and hybrid organic-inorganic abrasive particles being different from the particles (A), materials having a lower critical solution temperature LCST or an upper critical solution temperature UCST, oxidizing agents, passivating agents, charge reversal agents, complexing or chelating agents, frictive agents, stabilizing agents, rheology agents, surfactants, biocides, metal cations and organic solvents.

8. The aqueous polishing composition according to claim 7, **characterized in that** the biocide (D) is selected from the group consisting of water-soluble or water-dispersible N-substituted diazenium dioxides and N'-hydroxy-diazenium oxide salts.

9. A process for polishing substrates for electrical, mechanical and optical devices by contacting the substrate at least once with an aqueous polishing composition and polishing the substrate until the desired planarity is achieved, **characterized in that** the aqueous polishing composition according to anyone of the claims 1 to 8 is used.

10. The process according to claim 9, **characterized in that** the substrate comprises at least one layer containing or consisting of at least one dielectric silicon oxide material and at least one layer containing or consisting of silicon nitride.

11. The use of the aqueous polishing composition according to anyone of the claims 1 to 8 for manufacturing electrical, mechanical and optical devices.

## Patentansprüche

1. Wässrige Polierzusammensetzung mit einem pH-Wert in dem Bereich von 3 bis 11, umfassend
(A) anorganische Partikel, die Ceroxid enthalten oder daraus bestehen, in einer Menge von 0,01 bis 6 Gew.-% bezogen auf das Gesamtgewicht der Zusammensetzung,
(B) wenigstens ein anionisches Phosphat-Dispergiermittel, **dadurch gekennzeichnet, dass** das wasserlösliche kondensierte Phosphat (B) ausgewählt ist aus der Gruppe bestehend aus Metaphosphaten der allgemeinen Formel I:
[M⁺ₙ(PO₃)ₙ] (I);
und Polyphosphaten der allgemeinen Formel II und III:
M⁺ₙPₙO₃ₙ₊₁ (II);
M⁺H₂PₙO₃ₙ₊₁ (III);
wobei M Ammonium, Natrium oder Kalium ist und der Index n von 2 bis 10.000 beträgt und (B) in solchen Mengen verwendet wird, dass ein Gewichtsverhältnis von Ceroxid zu anionischem Phosphat-Dispergiermittel (B) von 20 bis 1000 entsteht;
(C) wenigstens eine polyhydrischer-AlkoholKomponente ausgewählt aus der Gruppe bestehend aus
(c1) polyhydrischen Alkoholen ausgewählt aus der Gruppe bestehend aus wasserlöslichen und wasserdispergierbaren, aliphatischen und cycloaliphatischen, monomeren, dimeren und oligomeren Polyolen mit wenigstens 4 Hydroxygruppen, die in dem wässrigen Medium nicht dissoziierbar sind, wobei der polyhydrische Alkohol (c1) in Mengen von 0,005 bis 5 Gew.-%, bezogen auf das Gesamtgewicht der Zusammensetzung, enthalten ist;
(c2) einem Gemisch bestehend aus
(c21) wenigstens einem polyhydrischen Alkohol ausgewählt aus der Gruppe bestehend aus wasserlöslichen und wasserdispergierbaren, aliphatischen und cycloaliphatischen Polyolen mit wenigstens 2 Hydroxygruppen, die in dem wässrigen Medium nicht dissoziierbar sind, wobei das Polyol (c21) in Mengen von 0,05 bis 5 Gew.-%, bezogen auf das Gesamtgewicht der Zusammensetzung, verwendet wird; und
(c22) wenigstens einem wasserlöslichen oder wasserdispergierbaren Polymer ausgewählt aus der Gruppe bestehend aus linearen und verzweigten Alkylenoxid-Homopolymeren, wobei das Polymer (c22) in Mengen von 0,005 bis 5 Gew.-%, bezogen auf das Gesamtgewicht der Zusammensetzung, verwendet wird, und Copolymeren (c221); und linearen und verzweigten, aliphatischen und cycloaliphatischen Poly(N-vinylamid)-Hompoplymeren und Copolymeren (c222); und
(c3) Gemischen von (c1) und (c2).

2. Wässrige Polierzusammensetzung gemäß Anspruch 1, **dadurch gekennzeichnet, dass** die wasserlöslichen und wasserdispergierbaren, aliphatischen und cycloaliphatischen, monomeren, dimeren und oligomeren Polyole (c1) mit wenigstens 4 Hydroxygruppen, die in dem wässrigen Medium nicht dissoziierbar sind, ausgewählt sind aus der Gruppe bestehend aus Erythrit, Pentaerytrit, Alditolen, Cyclitolen, Kohlenhydraten und Dimeren und Oligomeren von Glycerol, Erythrit, Pentaerytrit, Alditolen, Cyclitolen.

3. Wässrige Polierzusammensetzung gemäß Anspruch 2, **dadurch gekennzeichnet, dass** das Alditol (c1) ausgewählt ist aus der Gruppe bestehend aus Tetritolen, Pentitolen, Hexitolen, Heptitolen und Octitolen; das Cyclitol (c1) ausgewählt ist aus Inositolen; und das Kohlenhydrat (c1) ausgewählt ist aus der Gruppe bestehend aus Monosacchariden, Disacchariden, Oligosacchariden, Polysacchariden, Desoxyzuckern und Aminozuckern.

4. Wässrige Polierzusammensetzung gemäß Anspruch 3, **dadurch gekennzeichnet, dass** das Monosaccharid (c1) ausgewählt ist aus der Gruppe bestehend aus Allose, Altrose, Glucose, Mannose, Idose, Galactose und Talose.

5. Wässrige Polierzusammensetzung gemäß einem der Ansprüche 1 bis 4, **dadurch gekennzeichnet, dass** das wasserlösliche oder wasserdispergierbare, aliphatische oder cycloaliphatische Polyol (c21) mit 2 bis 3 Hydroxygruppen, die in dem wässrigen Medium nicht dissoziierbar sind, ausgewählt ist aus der Gruppe bestehend aus Ethylenglycol, Propylenglycol, Diethylenglycol, Triethylenglycol, Dipropylenglycol, Tripropylenglycol, Ethylenpropylenglycol, Diethylenpropylenglycol, Ethylendipropylenglycol, Glycerol, 1,2,3-Trihydroxy-n-butan, Trimethylolpropan und Gemischen davon; dass das wasserlösliche oder wasserdispergierbare, lineare oder verzweigte Alkylenoxid-Homopolymer oder -Copolymer (c221) ausgewählt ist aus der Gruppe bestehend aus Ethylenoxid- und Propylenoxid-Homopolymeren und -Copolymeren; und dass das lineare oder verzweigte, aliphatische oder cycloaliphatische Poly(N-vinylamid)-Hompoplymer oder -Copolymer (c222) ausgewählt ist aus der Gruppe bestehend aus Homopolymeren und Copolymeren von aliphatischen und cycloaliphatischen N-Vinylamidmonomeren ausgewählt aus der Gruppe bestehend aus N-Vinylacetamid, N-Vinylpyrrolidon, N-Vinylvalerolactam, N-Vinylcaprolactam, N-Vinylsuccinimid und Gemischen davon.

6. Wässrige Polierzusammensetzung gemäß einem der Ansprüche 1 bis 5, **dadurch gekennzeichnet, dass** sie wenigstens ein pH-Einstellmittel oder Puffermittel (E), das von den Komponenten (A), (B) und (C) verschieden ist, enthält.

7. Wässrige Polierzusammensetzung gemäß einem der Ansprüche 1 bis 6, **dadurch gekennzeichnet, dass** sie wenigstens eine funktionelle Komponente (D) enthält, die von den Komponenten (A), (B) und (C) verschieden ist, und die funktionelle Komponente (D) ausgewählt ist aus der Gruppe bestehend aus organischen, anorganischen und hybrid organisch-anorganischen abrasiven Partikeln, die von den Partikeln (A) verschieden sind, Materialien mit einer unteren kritischen Lösungstemperatur LCST oder einer oberen kritischen Lösungstemperatur UCST, Oxidationsmitteln, Passivierungsmitteln, Ladungsumkehrmitteln, Komplex- oder Chelatbildnern, Reibungsmitteln, Stabilisierungsmitteln, Rheologiemitteln, grenzflächenaktiven Mitteln, Bioziden, Metallkationen und organischen Lösungsmitteln.

8. Wässrige Polierzusammensetzung gemäß Anspruch 7, **dadurch gekennzeichnet, dass** das Biozid (D) ausgewählt ist aus der Gruppe bestehend aus wasserlöslichen oder wasserdispergierbaren N-substituierten Diazeniumdioxiden und N'-Hydroxy-diazeniumoxidsalzen.

9. Verfahren zum Polieren von Substraten für elektrische, mechanische und optische Vorrichtungen durch wenigstens einmaliges Inkontaktbringen des Substrats mit einer wässrige Polierzusammensetzung und Polieren des Substrats, bis die gewünschte Planarität erzielt ist, **dadurch gekennzeichnet, dass** die wässrige Polierzusammensetzung gemäß einem der Ansprüche 1 bis 8 verwendet wird.

10. Verfahren gemäß Anspruch 9, **dadurch gekennzeichnet, dass** das Substrat wenigstens eine Schicht, die wenigstens ein dielektrisches Siliciumoxidmaterial enthält oder daraus besteht, und wenigstens eine Schicht, die Siliciumnitrid enthält oder daraus besteht, umfasst.

11. Verwendung der wässrigen Polierzusammensetzung gemäß einem der Ansprüche 1 bis 8 für die Herstellung von elektrischen, mechanischen und optischen Vorrichtungen.

## Revendications

1. Composition aqueuse de polissage ayant un pH dans la plage de 3 à 11 et comprenant
(A) des particules inorganiques contenant ou constituées d'oxyde de cérium en une quantité de 0,01 à 6 % en poids sur la base du poids total de la composition
(B) au moins un agent de dispersion de phosphate anionique, **caractérisé en ce que** le phosphate condensé soluble dans l'eau (B) est choisi dans le groupe constitué de métaphosphates de formule générale I :
[M⁺ₙ(PO₃)ₙ] (I) ;
et de polyphosphates de formules générales II et III :
M⁺ₙPₙO₃ₙ₊₁ (II) ;
M⁺H₂PₙO₃ₙ₊₁ (III) ;
dans laquelle M est ammonium, sodium et potassium et l'indice n est de 2 à 10 000 et (B) est utilisé dans des quantités telles qu'un rapport en poids de l'oxyde de cérium à l'agent de dispersion de phosphate anionique (B) de 20 à 1000 soit obtenu,
(C) au moins un composant d'alcool polyhydrique choisi dans le groupe constitué de
(c1) des alcools polyhydriques choisis dans le groupe constitué de polyols monomères, dimères et oligomères, aliphatiques et cycloaliphatiques, solubles dans l'eau et dispersibles dans l'eau ayant au moins 4 groupes hydroxy qui ne sont pas dissociables dans le milieu aqueux, dans laquelle l'alcool polyhydrique (c1) est contenu dans des quantités de 0,005 à 5 % en poids, sur la base du poids total de la composition ;
(c2) un mélange constitué de
(c21) au moins un alcool polyhydrique choisi dans le groupe constitué de polyols aliphatiques et cycloaliphatiques, solubles dans l'eau et dispersibles dans l'eau ayant au moins 2 groupes hydroxy qui ne sont pas dissociables dans le milieu aqueux, dans laquelle le polyol (c21) est utilisé dans des quantités de 0,05 à 5 % en poids, sur la base du poids total de la composition ; et
(c22) au moins un polymère soluble dans l'eau ou dispersible dans l'eau choisi dans le groupe constitué d'homopolymères d'oxyde d'alkylène linéaires et ramifiés, dans laquelle le polymère (c22) est utilisé dans des quantités de 0,005 à 5 % en poids, sur la base du poids total de la composition et des copolymères (c221) ; et des homopolymères et copolymères de poly(N-vinylamide) aliphatiques et cycloaliphatiques, linéaires et ramifiés (c222) ; et
(c3) des mélanges de (c1) et (c2).

2. Composition aqueuse de polissage selon la revendication 1, **caractérisée en ce que** les polyols monomères, dimères et oligomères, aliphatiques et cycloaliphatiques, solubles dans l'eau et dispersibles dans l'eau (c1) ayant au moins 4 groupes hydroxy qui ne sont pas dissociables dans le milieu aqueux sont choisis dans le groupe constitué des érythritol, pentaérythritol, alditols, cyclitols, glucides et dimères et oligomères de glycérol, érythritol, pentaérythritol, alditols, cyclitols.

3. Composition aqueuse de polissage selon la revendication 2, **caractérisée en ce que** l'alditol (c1) est choisi dans le groupe constitué de tétritols, pentitols, hexitols, heptitols et octitols ; le cyclitol (c1) est choisi parmi des inositols ; et le glucide (c1) est choisi dans le groupe constitué de monosaccharides, disaccharides, oligosaccharides, polysaccharides, désoxysaccharides et sucres aminés.

4. Composition aqueuse de polissage selon la revendication 3, **caractérisée en ce que** le monosaccharide (c1) est choisi dans le groupe constitué des allose, altrose, glucose, mannose, idose, galactose et talose.

5. Composition aqueuse de polissage selon l'une quelconque des revendications 1 à 4, **caractérisée en ce que** le polyol aliphatique ou cycloaliphatique, soluble dans l'eau ou dispersible dans l'eau (c21) ayant 2 à 3 groupes hydroxy qui ne sont pas dissociables dans le milieu aqueux est choisi dans le groupe constitué des éthylène glycol, propylène glycol, diéthylène glycol, triéthylène glycol, dipropylène glycol, tripropylène glycol, éthylène propylène glycol, diéthylène propylène glycol, éthylène dipropylène glycol, glycérol, 1,2,3-trihydroxy-n-butane, triméthylolpropane, et des mélanges de ceux-ci ; **en ce que** l'homopolymère ou copolymère d'oxyde d'alkylène linéaire ou ramifié, soluble dans l'eau ou dispersible dans l'eau (c221) est choisi dans le groupe constitué d'homopolymères et copolymères d'oxyde d'éthylène et d'oxyde de propylène ; et que l'homopolymère ou copolymère de poly(N-vinylamide) aliphatique ou cycloaliphatique, linéaire ou ramifié (c222) est choisi dans le groupe constitué d'homopolymères et copolymères de monomères de N-vinylamide aliphatiques et cycloaliphatiques choisis dans le groupe constitué des N-vinylacétamide, N-vinylpyrrolidone, N-vinylvalérolactame, N-vinylcaprolactame, N-vinylsuccinimide et des mélanges de ceux-ci.

6. Composition aqueuse de polissage selon l'une quelconque des revendications 1 à 5, **caractérisée en ce qu'**elle contient au moins un agent d'ajustement du pH ou agent tampon (E) différent des composants (A), (B) et (C) .

7. Composition aqueuse de polissage selon l'une quelconque des revendications 1 à 6, **caractérisée en ce qu'**elle contient au moins un composant fonctionnel (D) différent des composants (A), (B) et (C), et le composant fonctionnel (D) est choisi dans le groupe constitué de particules abrasives organiques, inorganiques et hybrides organiques-inorganiques étant différentes des particules (A), de matériaux ayant une température de solution critique inférieure LCST ou une température de solution critique supérieure UCST, d'agents oxydants, d'agents de passivation, d'agents d'inversion de charge, d'agents complexants ou chélateurs, d'agents de friction, d'agents stabilisants, d'agents de rhéologie, de tensioactifs, de biocides, de cations métalliques et de solvants organiques.

8. Composition aqueuse de polissage selon la revendication 7, **caractérisée en ce que** le biocide (D) est choisi dans le groupe constitué de dioxydes de diazénium N-substitués et sels d'oxyde de N'-hydroxy-diazénium solubles dans l'eau ou dispersibles dans l'eau.

9. Procédé de polissage de substrats pour des dispositifs électriques, mécaniques et optiques par mise en contact du substrat au moins une fois avec une composition aqueuse de polissage et polissage du substrat jusqu'à ce que la planéité souhaitée soit obtenue, **caractérisé en ce que** la composition aqueuse de polissage selon l'une quelconque des revendications 1 à 8 est utilisée.

10. Procédé selon la revendication 9, **caractérisé en ce que** le substrat comprend au moins une couche contenant ou constituée d'au moins un matériau d'oxyde de silicium diélectrique et d'au moins une couche contenant ou constituée de nitrure de silicium.

11. Utilisation de la composition aqueuse de polissage selon l'une quelconque des revendications 1 à 8 pour fabriquer des dispositifs électriques, mécaniques et optiques.
